# EUROPÄISCHE PATENTSCHRIFT

(11) **EP 2 829 917 B1**
(45) Veröffentlichungstag und Bekanntmachung des Hinweises auf die Patenterteilung: **15.01.2020**
(21) Anmeldenummer: 14177805.0
(22) Anmeldetag: 21.07.2014
(51) Int. Cl.: G03F 7/20

(54) **Mikrolithographische Projektionsbelichtungsanlage**
Microlithographic projection exposure apparatus
Appareil microlithographique d'exposition par projection

(30) Priorität: 24.07.2013 DE 102013214459
(43) Veröffentlichungstag der Anmeldung: 28.01.2015
(73) Patentinhaber: Carl Zeiss SMT GmbH, 73447 Oberkochen (DE)
(72) Erfinder: Patra, Michael, 73447 Oberkochen (DE); Eisenmenger, Johannes, 89075 Ulm (DE); Schwab, Markus, 73434 Aalen (DE)
(74) Vertreter: Frank, Hartmut

(56) Entgegenhaltungen:
- WO-A1-2012/100791
- US-A1- 2011 117 503
- US-B1- 6 977 718
- ANDREW LYNCH ET AL: "Beam manipulation: prisms vs. mirrors", PHOTONIK INTERNATIONAL, Bd. 2009, Nr. 2, 12. November 2009 (2009-11-12), Seiten 45-47, XP055157575,

## Beschreibung

Die Erfindung betrifft eine mikrolithographische Projektionsbelichtungsanlage.

Mikrolithographische Projektionsbelichtungsanlagen werden zur Herstellung mikrostrukturierter Bauelemente, wie beispielsweise integrierter Schaltkreise oder LCD's, angewendet. Eine solche Projektionsbelichtungsanlage weist eine Beleuchtungseinrichtung und ein Projektionsobjektiv auf. Im Mikrolithographieprozess wird das Bild einer mit Hilfe der Beleuchtungseinrichtung beleuchteten Maske (= Retikel) mittels des Projektionsobjektivs auf ein mit einer lichtempfindlichen Schicht (Photoresist) beschichtetes und in der Bildebene des Projektionsobjektivs angeordnetes Substrat (z.B. ein Siliziumwafer) projiziert, um die Maskenstruktur auf die lichtempfindliche Beschichtung des Substrats zu übertragen.

Im Betrieb einer mikrolithographischen Projektionsbelichtungsanlage besteht der Bedarf, definierte Beleuchtungssettings, d.h. Intensitätsverteilungen in einer Pupillenebene der Beleuchtungseinrichtung, gezielt einzustellen. Hierzu ist außer der Verwendung diffraktiver optischer Elemente (sogenannter DOE's) auch der Einsatz von Spiegelanordnungen, z.B. aus WO 2005/026843 A2, bekannt. Solche Spiegelanordnungen umfassen eine Vielzahl unabhängig voneinander einstellbarer Mikrospiegel und ermöglichen die flexible Variation der in der Beleuchtungseinrichtung eingestellten Intensitätsverteilung.

Hierbei sind in der Praxis die maximal einstellbaren Kippwinkel der Spiegelelemente innerhalb einer solchen Spiegelanordnung zur Einstellung der jeweils gewünschten Beleuchtungssettings begrenzt (typischerweise auf wenige Grad), damit mechanische Probleme bei der Realisierung der Verkippung der Spiegelelemente (z.B. infolge einer Instabilität der dort typischerweise eingesetzten Festkörpergelenke) sowie gegebenenfalls Probleme der Wärmeabfuhr im Bereich der Spiegelanordnung vermieden werden. Diese Beschränkung der maximalen Kippwinkel innerhalb der Spiegelanordnung führt wiederum dazu, dass eine in der Beleuchtungseinrichtung typischerweise eingesetzte Fourier-Optik zur Umwandlung der Winkelverteilung des Beleuchtungslichtes in eine Ortsverteilung in der Pupillenebene typischerweise relativ große Brennweiten (von z.B. mehreren Metern) aufweisen muss.

Um diese Brennweiten mit noch vertretbarem Aufwand zu realisieren, ist es bekannt, die Fourier-Optik als optisches Zoom-System mit einer Mehrzahl refraktiver Linsen auszugestalten, was jedoch grundsätzlich den Material- und Kostenaufwand vergrößert. Des Weiteren kann die Ausgestaltung der Fourier-Optik als optisches Zoom-System mit einer Mehrzahl refraktiver Linsen auch insofern einen erhöhten konstruktiven Aufwand bei der Ausgestaltung des optischen Designs der Projektionsbelichtungsanlage bedeuten, als z.B. die räumlich ebenfalls erforderliche Unterbringung von Tragstrukturen, welche durch die zusätzlichen Linsen innerhalb des optischen Zoom-Systems nicht behindert werden darf, erschwert wird. Zum Stand der Technik wird lediglich beispielhaft auf WO 2005/026843 A2, US 2009/0116093 A1 und US 2006/055834 A1 verwiesen.

Die Druckschrift US 2011/117503 A1 offenbart eine Projektionsbelichtungsanlage mit einer Beleuchtungseinrichtung, einem Projektionsobjektiv, einer Umlenkeinrichtung, und einer Spiegelanordnung, welche eine Mehrzahl von Spiegelelementen aufweist.

Es ist eine Aufgabe der vorliegenden Erfindung, eine mikrolithographische Projektionsbelichtungsanlage bereitzustellen, welche eine flexible Variation der in der Beleuchtungseinrichtung eingestellten Intensitätsverteilung bei relativ geringem konstruktivem Aufwand und vergleichsweise kompakter Bauweise ermöglicht.

Diese Aufgabe wird gemäß den Merkmalen des unabhängigen Patentanspruchs 1 gelöst.

Der Erfindung liegt insbesondere das Konzept zugrunde, ausgehend von der Verwendung einer zur Variation der Intensitätsverteilung dienenden Spiegelanordnung mit unabhängig voneinander einstellbaren Spiegelelementen sowie einer Umlenkeinrichtung, welche bezogen auf den optischen Strahlengang nach der Spiegelanordnung wenigstens eine Umlenkfläche zur Umlenkung der optischen Achse aufweist, diese wenigstens eine Umlenkfläche nicht einfach als lediglich reflektierende (und im Übrigen brechkraftlose) Fläche auszugestalten, sondern bewusst mit Brechkraft zu versehen.

Diese Ausgestaltung der Umlenkfläche mit Brechkraft hat in vorteilhafter Weise zur Folge, dass eine - im weiteren optischen Strahlengang einer Beleuchtungseinrichtung typischerweise erforderliche - Umwandlung der Winkelverteilung des Beleuchtungslichtes in eine Ortsverteilung in einer im optischen Strahlengang nachfolgenden Pupillenebene mittels einer einfacher bzw. kompakter ausgelegten Optik erfolgen kann, da bei geeigneter Ausgestaltung der besagten Umlenkfläche hinsichtlich der durch diese Umlenkfläche bereitgestellten Brechkraft die für die vorstehend beschriebene Umwandlung benötigte optische Wirkung der betreffenden (Fourier-) Optik bereits teilweise durch besagte Umlenkfläche übernommen werden kann.

Unter der Formulierung, dass die Umlenkfläche "bezogen auf den optischen Strahlengang nach der Spiegelanordnung" angeordnet ist, ist zu verstehen, dass im Betrieb des optischen Systems durchlaufendes Licht zunächst auf die Spiegelanordnung und dann auf die Umlenkfläche trifft (da der optische Strahlengang von der Lichtquelle in Richtung zur Maske und weiter zum Substrat verläuft).

Hierbei geht die Erfindung insbesondere von der Überlegung aus, dass hinsichtlich einer solchen Fourier-Optik zur Umwandlung der Winkelverteilung des Beleuchtungslichtes in eine Ortsverteilung in der Pupillenebene typischerweise relativ große Brennweiten (von z.B. mehreren Metern) erforderlich sind, da die maximalen, innerhalb der Spiegelanordnung einstellbaren Kippwinkel der Spiegelelemente zur Einstellung der jeweils gewünschten Beleuchtungssettings (typischerweise auf wenige Grad) begrenzt sind. Um nun solche, vergleichsweise großen Brennweiten der benötigten Fourier-Optik bei noch vertretbaren Baulängen des optischen Systems bzw. der Beleuchtungseinrichtung realisieren zu können, ist eine Verkürzung der betreffenden Fourier-Optik im Sinne einer Ausgestaltung dieser Fourier-Optik als optisches Zoom-System wünschenswert.

Dadurch, dass nun gemäß der Erfindung durch wenigstens eine Umlenkfläche der Umlenkeinrichtung bereits Brechkraft in das optische System eingeführt wird und somit die benötigte optische Wirkung der (Fourier-) Optik schon teilweise durch besagte Umlenkfläche übernommen werden kann, kann erreicht werden, dass z.B. wenigstens eine refraktive Linse des optischen Zoom-Systems bzw. der Fourier-Optik entfällt, so dass eine Vermeidung bzw. Milderung der vorstehend beschriebenen Probleme erreicht werden kann.

Durch die erfindungsgemäße Ausgestaltung wenigstens einer Umlenkfläche der Umlenkeinrichtung mit Brechkraft kann der weitere Vorteil erreicht werden, dass die an die Spiegelanordnung hinsichtlich des durch deren Spiegelelemente zu realisierenden Kippwinkels zu stellenden Anforderungen reduziert werden, da nämlich trotz vergleichsweise geringerer Baulänge bzw. kompakter Bauweise des optischen Systems hinreichend große Brennweiten der Fourier-Optik bereitgestellt werden können, um die jeweils gewünschten Beleuchtungssettings zu erzeugen.

Aufgrund der somit möglichen Ausgestaltung der Spiegelanordnung mit geringeren maximalen Kippwinkeln der Spiegelelemente (von z.B. nicht mehr als ± 3°) lassen sich mechanische Probleme bei der Realisierung der Verkippung der Spiegelelemente (z.B. infolge einer Instabilität der dort typischerweise eingesetzten Festkörpergelenke) sowie gegebenenfalls Probleme der Wärmeabfuhr im Bereich der Spiegelanordnung vermeiden.

Gemäß einer Ausführungsform weist das optische System bezogen auf den optischen Strahlengang zwischen der Spiegelanordnung und einer nachfolgenden Pupillenebene genau eine Umlenkfläche auf, an welcher eine Umlenkung der optischen Achse auftritt.

Die Erfindung ist jedoch nicht auf die Ausgestaltung mit genau einer Umlenkfläche zwischen der Spiegelanordnung und einer nachfolgenden Pupillenebene beschränkt. In anderen Ausführungsformen der Erfindung kann das optische System bezogen auf den optischen Strahlengang zwischen der Spiegelanordnung und einer nachfolgenden Pupillenebene auch eine Mehrzahl von Umlenkflächen aufweisen. In diesem Falle handelt es sich vorzugsweise bei derjenigen Umlenkfläche, welche erfindungsgemäß mit Brechkraft ausgestaltet ist, um die im optischen Strahlengang erste dieser Umlenkflächen. Diese Ausgestaltung hat den Vorteil, dass bei der erforderlichen Strahlumformung im optischen System eine möglichst optimale Ausnutzung des zur Verfügung stehenden Bauraumes erfolgen kann.

In Ausführungsformen der Erfindung weist die wenigstens eine Umlenkfläche eine positive Brechkraft auf (besitzt also "sammelnde Wirkung").

Grundsätzlich besitzt eine Fourier-Optik, welche mittels einer einzelnen Brechkraft realisiert wird, eine Baulänge, die doppelt so groß wie ihre Brennweite ist, sofern die Fourier-Optik telezentrisch ist (d.h. die Fourier-Optik setzt nicht nur Winkel in einer Eingangsebene in Orte in einer Ausgangsebene um, sondern auch Orte in einer Eingangsebene in Winkel in eine Ausgangsebene). Bei einer nichttelezentrischen Fourier-Optik ist bei Verwendung nur einer Brechkraft auch eine kürzere Baulänge möglich. Eine Verkürzung des benötigten Bauraums einer Fourier-Optik kann insbesondere erreicht werden, wenn die Fourier-Optik aus mehreren mit Brechkräften versehenen Flächen besteht und die erste Brechkraft einer solchen Fourier-Optik sammelnde Wirkung besitzt. Mittels einer zerstreuenden ersten Brechkraft kann erreicht werden, daß sich der Bauraum verlängert.

Die im vorstehenden Absatz angegebenen "Regeln" beschreiben vorteilhafte Ausgestaltungen. Bei einer Abweichung von diesen Regeln ist es jedoch regelmäßig ebenfalls möglich, eine vollständig funktionsfähige Fourier-Optik zu erhalten (wobei dann jedoch die übrigen Brechkräfte der Fourier-Optik vergleichsweise stärker und damit ggf. ungünstiger sind).

Gemäß einer Ausführungsform ist die Umlenkeinrichtung als Prisma ausgestaltet.

Gemäß der Erfindung weist die Umlenkeinrichtung eine bezogen auf den optischen Strahlengang vor der Spiegelanordnung angeordnete erste Umlenkfläche und eine bezogen auf den optischen Strahlengang nach der Spiegelanordnung angeordnete zweite Umlenkfläche auf, wobei sowohl an der ersten Umlenkfläche als auch an der zweiten Umlenkfläche jeweils eine Umlenkung der optischen Achse auftritt.

Gemäß einer Ausführungsform weisen die Spiegelelemente der Spiegelanordnung einen maximalen Kippwinkel von nicht mehr als 5°, insbesondere nicht mehr als 4°, weiter insbesondere nicht mehr als 3°, auf.

Gemäß einer Ausführungsform bewirkt die wenigstens eine Umlenkfläche für Licht, welches das optische System im Betrieb durchläuft, eine Totalreflexion. Eine solche Ausgestaltung hat im Vergleich zu einer ebenfalls möglichen Realisierung der Umlenkfläche als Umlenkspiegel den Vorteil eines geringeren Lichtverlustes und damit einer Verbesserung der Transmissionseigenschaften des optischen Systems.

Die Erfindung ist jedoch auf die vorstehend beschriebene Ausnutzung von Totalreflexionen nicht beschränkt. So kann in weiteren Ausgestaltungen der Erfindung die wenigstens eine Umlenkfläche auch als Umlenkspiegel realisiert sein. Diese Ausgestaltung hat gegenüber der Ausnutzung von Totalreflexion wiederum den Vorteil, dass hinsichtlich der Platzierung der Umlenkfläche im optischen Design keine Beschränkung des Einfallwinkels an der Umlenkfläche auf Werte unterhalb des Grenzwinkels der Totalreflexion gegeben ist.

Gemäß der Erfindung ist bezogen auf den optischen Strahlengang nach der Umlenkeinrichtung eine Fourier-Optik angeordnet, welche eine Winkelverteilung von im Betrieb des optischen Systems auf die Fourier-Optik auftreffendem Licht in eine Ortsverteilung in einer im optischen Strahlengang nachfolgenden Pupillenebene umwandelt.

Gemäß einer Ausführungsform weist diese Fourier-Optik mehr als eine Linse auf. Des Weiteren weist diese Fourier-Optik in Ausführungsformen der Erfindung nicht mehr als vier, insbesondere nicht mehr als drei Linsen auf.

Gemäß einer Ausführungsform ist das optische System für eine Arbeitswellenlänge von weniger als 250 nm, insbesondere weniger als 200 nm, weiter insbesondere weniger als 160 nm, ausgelegt.

Die Erfindung betrifft ferner ein Verfahren zur mikrolithographischen Herstellung mikrostrukturierter Bauelemente nach Anspruch 10.

Weitere Ausgestaltungen der Erfindung sind der Beschreibung sowie den Unteransprüchen zu entnehmen.

Die Erfindung wird nachstehend anhand von in den beigefügten Abbildungen dargestellten Ausführungsbeispielen näher erläutert.

Es zeigen:
- Figur 1: eine schematische Darstellung zur Erläuterung des möglichen Aufbaus einer erfindungsgemäßen mikrolithographischen Projektionsbelichtungsanlage mit einem optischen System;
- Figur 2-3: schematische Darstellungen zur Erläuterung beispielhafter Ausführungsformen der vorliegenden Erfindung; und
- Figur 4: eine schematische Darstellung zur Erläuterung des Aufbaus eines optischen Systems gemäß dem Stand der Technik.

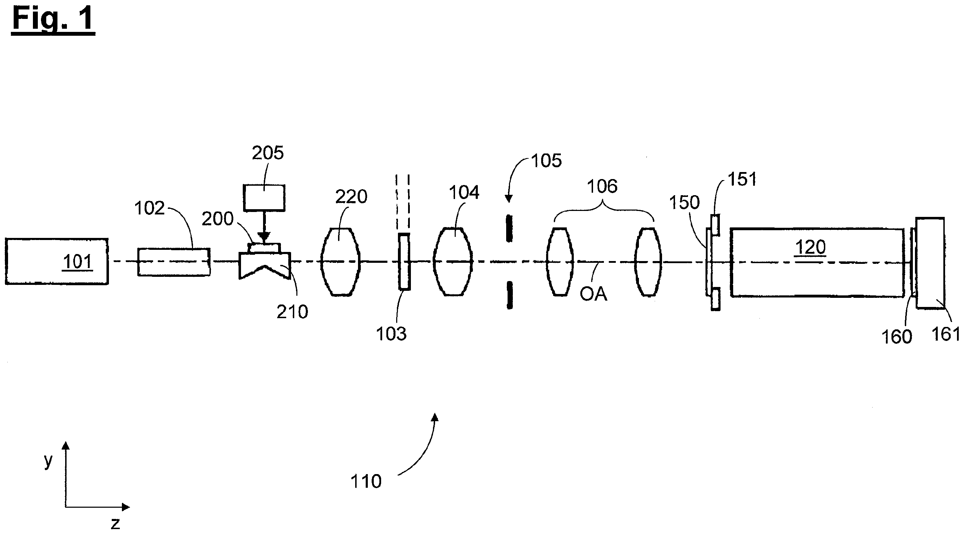

Im Weiteren wird zunächst unter Bezugnahme auf Fig. 1 ein prinzipieller möglicher Aufbau einer erfindungsgemäßen mikrolithographischen Projektionsbelichtungsanlage mit einem optischen System erläutert. Der grundsätzliche in Fig. 1 dargestellte Aufbau ist z.B. aus US 2009/0116093 A1 bekannt und gehört als solcher nicht zum beanspruchten Gegenstand der vorliegenden Anmeldung.

Die Projektionsbelichtungsanlage gemäß Fig. 1 weist eine Beleuchtungseinrichtung 110 sowie ein Projektionsobjektiv 120 auf. Die Beleuchtungseinrichtung 110 dient zur Beleuchtung einer Struktur tragenden Maske (Retikel) 150 mit Licht von einer Lichtquelleneinheit 101, welche beispielsweise einen ArF-Excimerlaser für eine Arbeitswellenlänge von 193 nm sowie eine ein paralleles Lichtbündel erzeugende Strahlformungsoptik umfasst. Generell sind die Beleuchtungseinrichtung 110 sowie das Projektionsobjektiv 120 bevorzugt für eine Arbeitswellenlänge von weniger als 250 nm, insbesondere weniger als 200 nm, weiter insbesondere weniger als 160 nm, ausgelegt.

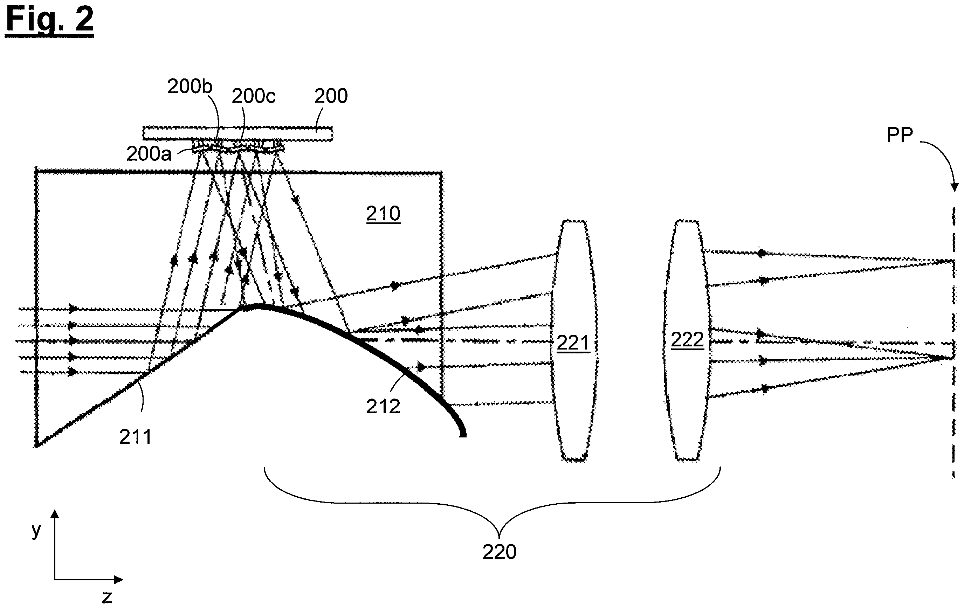

Gemäß Fig. 2 ist Bestandteil der Beleuchtungseinrichtung 110 insbesondere eine Spiegelanordnung 200, wie im Weiteren unter Bezugnahme auf Fig. 2ff. näher erläutert wird. Eine solche Spiegelanordnung 200 wird mitunter auch als MMA ("micro mirror array" = Mikrospiegelanordnung) oder auch als räumlicher Lichtmodulator (= "spatial light modulator") bezeichnet und weist - wie in Fig. 2 schematisch angedeutet - eine Mehrzahl von Spiegelelementen 200a, 200b, 200c,... auf, die zur Veränderung einer Winkelverteilung des von der Spiegelanordnung 200 reflektierten Lichtes unabhängig voneinander verstellbar sind. Eine Ansteuerung dieser Verstellung erfolgt gemäß Fig. 1 über eine Ansteuerungseinheit 205 unter Verwendung geeigneter Aktuatoren. Die Spiegelelemente 200a, 200b, 200c,... können jeweils individuell, z.B. in einem Winkelbereich von -2.5° bis +2.5°, verkippt werden. In Lichtausbreitungsrichtung vor der Spiegelanordnung 200 kann in für sich bekannter Weise eine Mikrolinsenanordnung (nicht dargestellt) vorgesehen sein, welche eine Vielzahl von Mikrolinsen zur gezielten Fokussierung auf die Spiegelelemente 200a, 200b, 200c,... sowie zur Verringerung oder Vermeidung von Lichtverlust sowie Streulichtgenerierung in den Bereichen zwischen den Spiegelelementen 200a, 200b, 200c,... durch Überstrahlung der Spiegelelemente aufweist.

Durch eine geeignete Verkippungsanordnung der Spiegelelemente 200a, 200b, 200c,... in der Spiegelanordnung 200 kann in einer Pupillenebene der Beleuchtungseinrichtung 110 aus Fig. 1 eine gewünschte Licht- bzw. Intensitätsverteilung, z.B. ein annulares Beleuchtungssetting oder auch ein Dipol-Setting oder ein Quadrupol-Setting, ausgebildet werden, indem das (ggf. zuvor homogenisierte und kollimierte) Laserlicht je nach gewünschtem Beleuchtungssetting durch die Spiegelelemente 200a, 200b, 200c,... der Spiegelanordnung 200 jeweils in die entsprechende Richtung gelenkt wird.

Gemäß Fig. 1 trifft das von der Lichtquelleneinheit 101 sowie einer Einrichtung 102 zur Einstellung des Polarisationszustandes kommende Licht vor dem Auftreffen auf die Spiegelanordnung 200 zunächst auf eine Umlenkeinrichtung 210, über welche das Beleuchtungslicht an einer ersten Umlenkfläche 211 der Umlenkeinrichtung 210 in Richtung der Spiegelanordnung 200 abgelenkt und nach Reflexion an der Spiegelanordnung 200 von einer zweiten Umlenkfläche 212 der Umlenkeinrichtung 210 wieder entlang der ursprünglichen Ausbreitungsrichtung umgelenkt wird. Somit weist die Umlenkeinrichtung 210 bezogen auf die Lichtausbreitungsrichtung sowohl vor als auch nach der Spiegelanordnung 200 jeweils eine Umlenkfläche 211 bzw. 212 auf.

Aufgrund der Umlenkeinrichtung 210 wird es zunächst ermöglicht, die zur flexiblen Einstellung unterschiedlicher Beleuchtungssettings dienende Spiegelanordnung 200 nach Art eines Moduls (gewissermaßen vergleichbar mit dem "Plug-and-Play"-Prinzip) in einer zur Einstellung eines gewünschten Beleuchtungssettings z.B. mit einem diffraktiven optischen Element (DOE) ausgestatteten Beleuchtungseinrichtung durch Ersatz dieses DOE's einzusetzen, da das Beleuchtungslicht mittels der Umlenkeinrichtung 210 und ohne Erfordernis weiterer Modifikationen im übrigen optischen Design der Beleuchtungseinrichtung in einfacher Weise aus dem optischen Strahlengang ausgekoppelt sowie in den optischen Strahlengang wieder eingekoppelt wird.

Mit anderen Worten kann erfindungsgemäß bei vollständiger Kompatibilität zum vorhandenen optischen Design der jeweils bestehenden und z.B. mit einem DOE ausgestatteten Beleuchtungseinrichtung eine zusätzliche Ausrüstung der Beleuchtungseinrichtung dahingehend erfolgen, dass durch Austausch dieses DOE gegen das erfindungsgemäße Modul zusätzlich die flexible Einstellung unterschiedlicher Beleuchtungssettings erfolgen kann. Die vorstehend beschriebene Ein- bzw. Auskopplung des Beleuchtungslichtes ist ferner insofern vorteilhaft, als hierdurch gegebenenfalls eine optimale Ausnutzung des verfügbaren Bauraums ermöglicht wird.

In Lichtausbreitungsrichtung nach der Umlenkeinrichtung 210 befindet sich im Strahlengang eine Fourier-Optik 220 in Form eines optischen Zoom-Systems, welche in Fig. 1 vereinfacht als einzige Linse dargestellt ist und dazu dient, die Winkelverteilung des auf die Fourier-Optik 220 auftreffenden Lichtes in eine Ortsverteilung in der nachfolgenden Pupillenebene PP umzuwandeln. Eine solche Fourier-Optik wird auch als Kondensor bezeichnet.

Im Strahlengang folgen eine Lichtmischeinrichtung 103, welche z.B. eine zur Erzielung einer Lichtmischung geeignete Anordnung aus mikrooptischen Elementen aufweisen kann, sowie eine Linsengruppe 104, hinter der sich eine Feldebene mit einem Retikel-Maskierungssystem (REMA) 105 befindet, welches durch ein in Lichtausbreitungsrichtung nachfolgendes REMA-Objektiv 106 auf die Struktur tragende, in einer weiteren Feldebene auf einem Maskentisch (auch üblicherweise bezeichnet als "mask stage" oder "reticle stage") 151 angeordnete Maske (Retikel) 150 abgebildet wird und dadurch den ausgeleuchteten Bereich auf dem Retikel begrenzt.

Die Struktur tragende Maske 150 wird mit dem Projektionsobjektiv 120 auf ein mit einer lichtempfindlichen Schicht versehenes Substrat 160 bzw. einen Wafer, welcher auf einem Wafertisch (auch üblicherweise bezeichnet als "wafer stage") 161 angeordnet ist, abgebildet. Das Projektionsobjektiv 120 kann insbesondere für den Immersionsbetrieb ausgelegt sein. Ferner kann es eine numerische Apertur NA größer als 0.85, insbesondere größer als 1.1, und insbesondere größer als 1.3, aufweisen.

Im Weiteren wird unter Bezugnahme auf Fig. 2 die Ausgestaltung der Umlenkeinrichtung 210 sowie deren Funktionsweise gemäß einer beispielhaften Ausführungsform der vorliegenden Erfindung erläutert.

Gemäß Fig. 2 ist die Umlenkeinrichtung 210 derart ausgestaltet, dass die bezogen auf den optischen Strahlengang nach der Spiegelanordnung 210 angeordnete Umlenkfläche 212 Brechkraft aufweist.

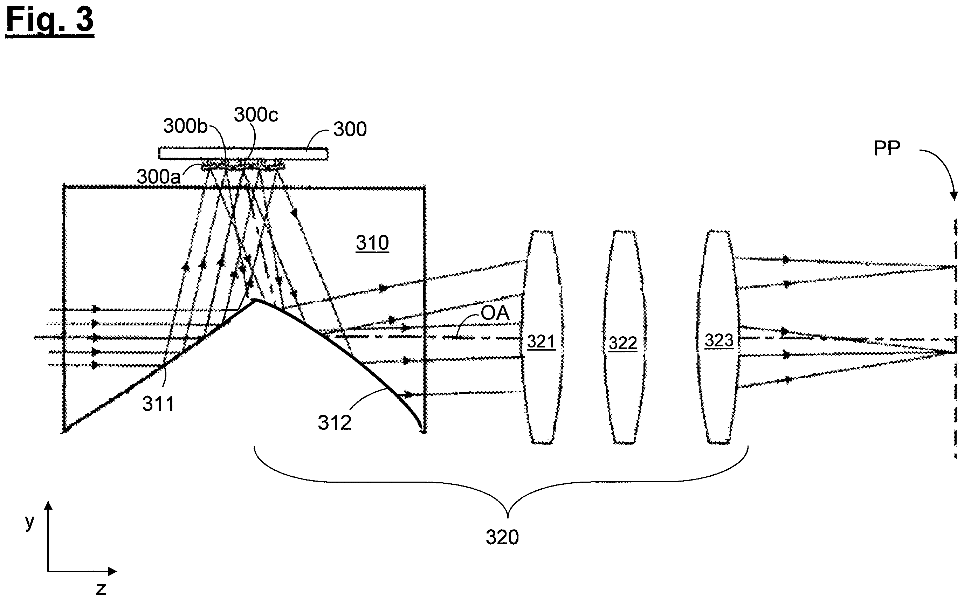

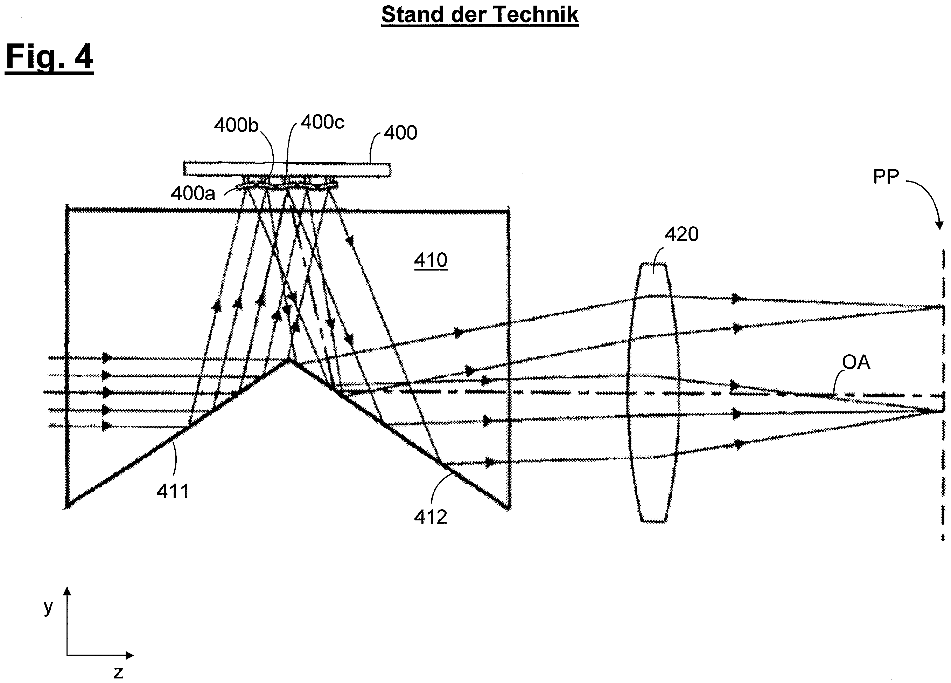

Mit anderen Worten bewirkt die Umlenkfläche 212 nicht lediglich eine brechkraftlose Reflexion zur Umlenkung der optischen Achse OA des optischen Systems bzw. der Beleuchtungseinrichtung, wie dies in der eine herkömmliche, für sich aus US 2009/0116093 A1 bekannte Anordnung zeigenden Fig. 4 der Fall ist. Vielmehr führt gemäß der Erfindung die Umlenkfläche 212 bereits Brechkraft in das optische System ein mit der Folge, dass ein Teil der von der Fourier-Optik 220 bereitzustellenden optischen Wirkung (nämlich der Umwandlung der Winkelverteilung des Beleuchtungslichtes in eine Ortsverteilung in der im Strahlengang nachfolgenden Pupillenebene PP) bereits von dieser Umlenkfläche 212 wahrgenommen werden kann, so dass die Umlenkfläche 212 optisch - aufgrund ihrer Brechkraft - funktionell zu einem Teil der Fourier-Optik 220 wird. Hieraus ergibt sich wiederum der Vorteil, dass die besagte Fourier-Optik 220 (welche typischerweise ferner eine Mehrzahl refraktiver Linsen aufweist, wobei in Fig. 2 lediglich exemplarisch zwei Linsen 221, 222 und in Fig. 3 drei Linsen 321, 322, 323 dargestellt sind) mit im Vergleich zu einer brechkraftlosen Ausgestaltung der Umlenkfläche 212 verkürzten Baulänge und somit kompakter ausgestaltet werden kann. Insbesondere kann diese kompaktere Ausgestaltung der Fourier-Optik 220 bedeuten, dass zumindest eine der refraktiven Linsen der Fourier-Optik 220 weggelassen werden kann.

Fig. 3 zeigt in schematischer Darstellung eine entsprechende Anordnung mit drei Linsen 321, 322, 323 der Fourier-Optik 320, wobei im Vergleich zu Fig. 2 analoge bzw. im Wesentlichen funktionsgleiche Elemente mit um "100" erhöhten Bezugsziffern bezeichnet sind.

Wenngleich gemäß Fig. 2 bzw. Fig. 3 die exemplarisch eingezeichneten Linsen 221, 222 bzw. 321-232 der Fourier-Optik 220 bzw. 320 im optischen Strahlengang unmittelbar auf die Umlenkfläche 212 bzw. 312 der Umlenkeinrichtung 210 bzw. 310 folgen, ist die Erfindung nicht hierauf beschränkt. Vielmehr können in weiteren Ausführungsformen der Erfindung auch eine oder mehrere weitere Umlenkflächen zwischen der Umlenkfläche 212 bzw. 312 und den weiteren Linsen 221, 222 bzw. 321-323 der Fourier-Optik 220 bzw. 320 (bzw. deren ersten refraktiver Linse 221 bzw. 321) vorgesehen sein.

Vorzugsweise ist auch im Falle der vorstehend erwähnten Ausgestaltung mit mehreren Umlenkflächen zwischen der Spiegelanordnung 200 und der Fourier-Optik 220 die bezogen auf den optischen Strahlengang erste dieser Umlenkflächen mit Brechkraft ausgestaltet, da auf diese Weise der zur Verfügung stehende Bauraum für die zu bewirkende Strahlumformung optimal ausgenutzt werden kann. Die Erfindung ist jedoch auch auf diese Ausgestaltung prinzipiell nicht beschränkt, so dass auch Ausgestaltungen als von der vorliegenden Anmeldung umfasst gelten sollen, bei denen von einer Mehrzahl von Umlenkflächen zwischen der Spiegelanordnung 200 und der ersten refraktiven Linse 221 der Fourier-Optik 220 nicht die bezogen auf den optischen Strahlengang erste, sondern eine andere dieser Umlenkflächen mit Brechkraft versehen ist. Des Weiteren können auch zwei oder mehr solcher Umlenkflächen Brechkraft aufweisen.

Wie aus Fig. 2 ersichtlich erfolgt in dem dargestellten Ausführungsbeispiel an den Umlenkflächen 211, 212 der Umlenkeinrichtung 210 die Strahlumlenkung des Beleuchtungslichtes jeweils über Totalreflexion, d.h. das Beleuchtungslicht trifft auf die betreffenden Umlenkflächen 211, 212 jeweils unter einem Einfallswinkel auf, der kleiner als der Grenzwinkel für Totalreflexion für die betreffende Wellenlänge (z.B. 193 nm) ist, d.h. der Strahl fällt flacher als dieser Grenzwinkel ein. Der Einfallswinkel kann z.B. um 1°, insbesondere um 5° kleiner als der Grenzwinkel für Totalreflexion sein, was u.a. die Auswirkung endlicher Rauigkeiten auf den Umlenkflächen 211, 212 verringert. Mittels Totalreflexion kann aufgrund der Minimierung von Reflexionsverlusten eine besonders hohe Transmission in dem erfindungsgemäßen optischen System erzielt werden. Die Erfindung ist jedoch auf diese Ausgestaltung nicht beschränkt, so dass in weiteren Ausführungsformen die Umlenkflächen 211, 212 auch durch reflektierende Spiegelflächen in Form von Umlenkspiegeln realisiert werden können (in welchem Falle die genannte Einschränkung auf kleinere Einfallswinkel als der Grenzwinkel für Totalreflexion entfällt).

Wie ebenfalls aus Fig. 2 ersichtlich ist, sind die Spiegelanordnung 200 sowie auch die Umlenkeinrichtung 210 derart angeordnet, dass die Spiegelanordnung 200 unter im Wesentlichen senkrechtem Lichteinfall betrieben wird, wobei die Umlenkeinrichtung 210 bzw. deren Umlenkflächen 211, 212 eine zweimalige Umlenkung (bzw. "Knickung") der optischen Achse um einen Winkel von 90°, entsprechend einer insgesamt resultierende Umlenkung um 180°, bewirkt. Wenngleich der Betrieb der Spiegelanordnung 200 mit im Wesentlichen senkrechtem Lichteinfall grundsätzlich vorteilhaft ist, ist die Erfindung auch hierauf nicht beschränkt, so dass in weiteren Ausführungsformen auch Umlenkungen der optischen Achse (etwa an den Umlenkflächen 211, 212 der Umlenkeinrichtung 210) um andere Winkel realisiert werden können.

Es versteht sich für den Fachmann, dass die Reichweite der Erfindung nur im Sinne der beigefügten Patentansprüche beschränkt ist.

## Patentansprüche

1. Mikrolithographische Projektionsbelichtungsanlage mit einer Beleuchtungseinrichtung (110) und einem Projektionsobjektiv (120), wobei die Beleuchtungseinrichtung (110) ein optisches System mit einer optischen Achse (OA) aufweist, wobei das optische System aufweist:
• wenigstens eine Spiegelanordnung (200, 300), welche eine Mehrzahl von Spiegelelementen (200a, 200b, 200c, 300a, 300b, 300c) aufweist, wobei diese Spiegelelemente zur Veränderung einer Winkelverteilung des von der Spiegelanordnung reflektierten Lichtes unabhängig voneinander verstellbar sind; und
• eine Umlenkeinrichtung (210, 310), welche eine bezogen auf den optischen Strahlengang vor der Spiegelanordnung (200, 300) angeordnete erste Umlenkfläche (211, 311) und eine bezogen auf den optischen Strahlengang nach der Spiegelanordnung (200, 300) angeordnete zweite Umlenkfläche (212, 312) aufweist, wobei sowohl an der ersten Umlenkfläche (211, 311) als auch an der zweiten Umlenkfläche (212, 312) jeweils eine Umlenkung der optischen Achse (OA) des optischen Systems auftritt;
• wobei die zweite Umlenkfläche (212, 312) eine sammelnde oder zerstreuende Wirkung aufweist,
dadurchgekennzeichnet, dass
bezogen auf den optischen Strahlengang nach der Spiegelanordnung (200, 300) eine Fourier-Optik (220, 320) angeordnet ist, welche eine Winkelverteilung von im Betrieb des optischen Systems auf die Fourier-Optik (220, 320) auftreffendem Licht in eine Ortsverteilung in einer im optischen Strahlengang nachfolgenden Pupillenebene (PP) umwandelt, wobei bezogen auf den optischen Strahlengang die zweite Umlenkfläche (212, 312) und die Fourier-Optik (220, 320) zwischen der Spiegelanordnung (200, 300) und der Pupillenebene (PP) angeordnet sind, und wobei die zweite Umlenkfläche (212, 312) einen Teil dieser Fourier-Optik (220, 320) bildet.

2. Mikrolithographische Projektionsbelichtungsanlage nach Anspruch 1, **dadurch gekennzeichnet, dass** dieses bezogen auf den optischen Strahlengang nach der Spiegelanordnung (200, 300) eine Mehrzahl von Umlenkflächen, an welchen jeweils eine Umlenkung der optischen Achse (OA) auftritt, aufweist.

3. Mikrolithographische Projektionsbelichtungsanlage nach Anspruch 1 oder 2, **dadurch gekennzeichnet, dass** die Umlenkeinrichtung (210, 310) als Prisma ausgestaltet ist.

4. Mikrolithographische Projektionsbelichtungsanlage nach einem der Ansprüche 1 bis 3, **dadurch gekennzeichnet, dass** die Spiegelelemente (200a, 200b, 200c, 300a, 300b, 300c) der Spiegelanordnung (200, 300) einen maximalen Kippwinkel von nicht mehr als 5°, insbesondere nicht mehr als 4°, weiter insbesondere nicht mehr als 3°, aufweisen.

5. Mikrolithographische Projektionsbelichtungsanlage nach einem der Ansprüche 1 bis 4, **dadurch gekennzeichnet, dass** die erste Umlenkfläche (211, 311) und die zweite Umlenkfläche (212, 312) für Licht, welches das optische System im Betrieb durchläuft, jeweils eine Totalreflexion bewirken.

6. Mikrolithographische Projektionsbelichtungsanlage nach einem der Ansprüche 1 bis 4, **dadurch gekennzeichnet, dass** die erste Umlenkfläche und die zweite Umlenkfläche jeweils als Umlenkspiegel ausgebildet sind.

7. Mikrolithographische Projektionsbelichtungsanlage nach einem der vorhergehenden Ansprüche, **dadurch gekennzeichnet, dass** diese Fourier-Optik (220, 320) mehr als eine Linse aufweist.

8. Mikrolithographische Projektionsbelichtungsanlage nach einem der vorhergehenden Ansprüche, **dadurch gekennzeichnet, dass** diese Fourier-Optik (220, 320) nicht mehr als vier, insbesondere nicht mehr als drei Linsen aufweist.

9. Mikrolithographische Projektionsbelichtungsanlage nach einem der vorhergehenden Ansprüche, **dadurch gekennzeichnet, dass** dieses für eine Arbeitswellenlänge von weniger als 250 nm, insbesondere weniger als 200 nm, weiter insbesondere weniger als 160 nm, ausgelegt ist.

10. Verfahren zur mikrolithographischen Herstellung mikrostrukturierter Bauelemente mit folgenden Schritten:
• Bereitstellen eines Substrats (160), auf das zumindest teilweise eine Schicht aus einem lichtempfindlichen Material aufgebracht ist;
• Bereitstellen einer Maske (150), die abzubildende Strukturen aufweist;
• Bereitstellen einer mikrolithographischen Projektionsbelichtungsanlage nach einem der Ansprüche 1 bis 9; und
• Projizieren wenigstens eines Teils der Maske (150) auf einen Bereich der Schicht mit Hilfe der Projektionsbelichtungsanlage.

## Claims

1. Microlithographic projection exposure apparatus having an illumination device (110) and a projection lens (120), wherein the illumination device (110) has an optical system having an optical axis (OA), wherein the optical system has:
• at least one mirror arrangement (200, 300) having a plurality of mirror elements (200a, 200b, 200c, 300a, 300b, 300c), wherein these mirror elements are adjustable independently of one another in order to change an angular distribution of the light reflected by the mirror arrangement; and
• a deflection device (210, 310) having a first deflection surface (211, 311) arranged upstream of the mirror arrangement (200, 300) based on the optical beam path and a second deflection surface (212, 312) arranged downstream of the mirror arrangement (200, 300) based on the optical beam path, wherein the optical axis (OA) of the optical system is respectively deflected both at the first deflection surface (211, 311) and at the second deflection surface (212, 312);
• wherein the second deflection surface (212, 312) has a converging or diverging effect, **characterized in that**
Fourier optics (220, 320) are arranged downstream of the mirror arrangement (200, 300) based on the optical beam path and convert an angular distribution of light impinging on the Fourier optics (220, 320) during operation of the optical system into a spatial distribution in a pupil plane (PP) following in the optical beam path, wherein the second deflection surface (212, 312) and the Fourier optics (220, 320) are arranged between the mirror arrangement (200, 300) and the pupil plane (PP) based on the optical beam path, and wherein the second deflection surface (212, 312) forms part of these Fourier optics (220, 320).

2. Microlithographic projection exposure apparatus according to Claim 1, **characterized in that** it has a plurality of deflection surfaces, at which the optical axis (OA) is respectively deflected, downstream of the mirror arrangement (200, 300) based on the optical beam path.

3. Microlithographic projection exposure apparatus according to Claim 1 or 2, **characterized in that** the deflection device (210, 310) is in the form of a prism.

4. Microlithographic projection exposure apparatus according to one of Claims 1 to 3, **characterized in that** the mirror elements (200a, 200b, 200c, 300a, 300b, 300c) of the mirror arrangement (200, 300) have a maximum tilt angle of no more than 5°, in particular no more than 4°, more particularly no more than 3°.

5. Microlithographic projection exposure apparatus according to one of Claims 1 to 4, **characterized in that** the first deflection surface (211, 311) and the second deflection surface (212, 312) each effect total internal reflection for light which runs through the optical system during operation.

6. Microlithographic projection exposure apparatus according to one of Claims 1 to 4, **characterized in that** the first deflection surface and the second deflection surface are each in the form of a deflection mirror.

7. Microlithographic projection exposure apparatus according to one of the preceding claims, **characterized in that** these Fourier optics (220, 320) have more than one lens element.

8. Microlithographic projection exposure apparatus according to one of the preceding claims, **characterized in that** these Fourier optics (220, 320) have no more than four, in particular no more than three, lens elements.

9. Microlithographic projection exposure apparatus according to one of the preceding claims, **characterized in that** it is designed for an operating wavelength of less than 250 nm, in particular less than 200 nm, more particularly less than 160 nm.

10. Method for the microlithographic production of microstructured components, having the following steps of:
• providing a substrate (160) to which a layer of a light-sensitive material is at least partially applied;
• providing a mask (150) having structures to be imaged;
• providing a microlithographic projection exposure apparatus according to one of Claims 1 to 9; and
• projecting at least one part of the mask (150) onto a region of the layer with the aid of the projection exposure apparatus.

## Revendications

1. Installation d'éclairage par projection microlithographique, comprenant un dispositif d'éclairage (110) et un objectif de projection (120), le dispositif d'éclairage (110) possédant un système optique pourvu d'un axe optique (OA), le système optique comprenant :
* au moins un arrangement de miroirs (200, 300) qui possède une pluralité d'éléments de miroir (200a, 200b, 200c, 300a, 300b, 300c), ces éléments de miroir pouvant être positionnés indépendamment les uns des autres en vue de modifier une distribution angulaire de la lumière réfléchie par l'arrangement de miroir ; et
* un dispositif de renvoi (210, 310), qui possède une première surface de renvoi (211, 311), disposée avant l'arrangement de miroirs (200, 300) en référence au trajet de rayon optique, et une deuxième surface de renvoi (212, 312), disposée après l'arrangement de miroirs (200, 300) en référence au trajet de rayon optique, un renvoi de l'axe optique (OA) du système optique se produisant respectivement à la fois au niveau de la première surface de renvoi (211, 311) et au niveau de la deuxième surface de renvoi (212, 312) ;
* la deuxième surface de renvoi (212, 312) possédant un effet focalisant ou divergent ;
**caractérisée en ce que**
une optique de Fourier (220, 320) est disposée après l'arrangement de miroirs (200, 300) en référence au trajet de rayon optique, laquelle convertit une distribution angulaire de la lumière incidente sur l'optique de Fourier (220, 320) durant le fonctionnement du système optique en une distribution locale dans un plan pupillaire (PP) qui suit dans le trajet de rayon optique, la deuxième surface de renvoi (212, 312) et l'optique de Fourier (220, 320), en référence au trajet de rayon optique, étant disposées entre l'arrangement de miroirs (200, 300) et le plan pupillaire (PP) et la deuxième surface de renvoi (212, 312) formant une partie de cette optique de Fourier (220, 320).

2. Installation d'éclairage par projection microlithographique selon la revendication 1, **caractérisée en ce que** celle-ci possède, après l'arrangement de miroirs (200, 300) en référence au trajet de rayon optique, une pluralité de surfaces de renvoi au niveau desquelles se produit respectivement un renvoi de l'axe optique (OA).

3. Installation d'éclairage par projection microlithographique selon la revendication 1 ou 2, **caractérisée en ce que** le dispositif de renvoi (210, 310) est réalisé sous la forme d'un prisme.

4. Installation d'éclairage par projection microlithographique selon l'une des revendications 1 à 3, **caractérisée en ce que** les éléments de miroir (200a, 200b, 200c, 300a, 300b, 300c) de l'arrangement de miroirs (200, 300) présentent un angle d'inclinaison maximal n'excédant pas 5°, notamment n'excédant pas 4°, encore notamment n'excédant pas 3°.

5. Installation d'éclairage par projection microlithographique selon l'une des revendications 1 à 4, **caractérisée en ce que** la première surface de renvoi (211, 311) et la deuxième surface de renvoi (212, 312) occasionnent respectivement une réflexion totale pour la lumière qui traverse le système optique durant le fonctionnement.

6. Installation d'éclairage par projection microlithographique selon l'une des revendications 1 à 4, **caractérisée en ce que** la première surface de renvoi et la deuxième surface de renvoi sont respectivement réalisées sous la forme de miroirs de renvoi.

7. Installation d'éclairage par projection microlithographique selon l'une des revendications précédentes, **caractérisée en ce que** cette optique de Fourier (220, 320) possède plus d'une lentille.

8. Installation d'éclairage par projection microlithographique selon l'une des revendications précédentes, **caractérisée en ce que** cette optique de Fourier (220, 320) ne possède pas plus de quatre, notamment pas plus de trois lentilles.

9. Installation d'éclairage par projection microlithographique selon l'une des revendications précédentes, **caractérisée en ce que** celle-ci est conçue pour une longueur d'onde de travail de moins de 250 nm, notamment de moins de 200 nm, encore notamment de moins de 160 nm.

10. Procédé de fabrication microlithographique de composants microstructurés, comprenant les étapes suivantes :
* fourniture d'un substrat (160) sur lequel est appliquée au moins partiellement une couche d'un matériau photosensible ;
* fourniture d'un masque (150) qui présente des structures à représenter ;
* fourniture d'une installation d'éclairage par projection microlithographique selon l'une des revendications 1 à 9 ; et
* projection d'au moins une partie du masque (150) sur une zone de la couche à l'aide de l'installation d'éclairage par projection.
